# EUROPÄISCHE PATENTSCHRIFT

(11) **EP 3 209 809 B1**
(45) Veröffentlichungstag und Bekanntmachung des Hinweises auf die Patenterteilung: **05.12.2018**
(21) Anmeldenummer: 15781046.6
(22) Anmeldetag: 01.10.2015
(51) Int. Cl.: C23C 14/12, C23C 16/448, C23C 16/455, C23C 14/24

(54) **TEMPERIERTE GASZULEITUNG MIT AN MEHREREN STELLEN EINGESPEISTEN VERDÜNNUNGSGASSTRÖMEN**
TEMPERATURE-CONTROLLED GAS SUPPLY LINE WITH DILUTION GAS FLOWS SUPPLIED AT MULTIPLE LOCATIONS
CONDUITE D'ARRIVÉE DE GAZ THERMO-RÉGULÉE COMPRENANT DES COURANTS DE GAZ DE DILUTION INJECTÉS À PLUSIEURS ENDROITS

(30) Priorität: 24.10.2014 DE 102014115497
(43) Veröffentlichungstag der Anmeldung: 30.08.2017
(73) Patentinhaber: Aixtron SE, 52134 Herzogenrath (DE)
(72) Erfinder: GERSDORFF, Markus, 52134 Herzogenrath (DE); DAUELSBERG, Martin, 52074 Aachen (DE); PAGADALA GOPI, Baskar, 52072 Aachen (DE); LONG, Michael, 52134 Herzogenrath (DE)
(74) Vertreter: Grundmann, Dirk
(86) Internationale Anmeldenummer: PCT/EP2015/072669
(87) Internationale Veröffentlichungsnummer: WO 2016/062514

(56) Entgegenhaltungen:
- DE-A1- 10 212 923
- US-A1- 2003 054 099
- US-A1- 2009 087 545
- US-A1- 2010 092 665

## Beschreibung

Die Erfindung betrifft eine Vorrichtung und ein Verfahren zum Abscheiden ein oder mehrerer insbesondere organischer Schichten auf einem Substrat, mit einer einen Verdampfer aufweisenden Prozessgasquelle, in welchem Verdampfer ein fester oder flüssiger Ausgangsstoff durch Zufuhr von mit einer Quellentemperiereinrichtung erzeugten Wärme bei einer Quellentemperatur in einen gasförmigen Ausgangsstoff verdampfbar ist, wobei in den Verdampfer eine Trägergaszuleitung mündet, zur Einspeisung eines Trägergasstroms zum Transport des gasförmigen Ausgangsstoffs aus dem Verdampfer in eine erste Transportleitung, wobei die erste Transportleitung mit einer Leitungstemperiereinrichtung auf eine Leitungstemperatur temperierbar ist, und in die erste Transportleitung eine erste Verdünnungsgaszuleitung mündet, zur Einspeisung eines Verdünnungsgasstroms in die erste Transportleitung, wobei die erste Verdünnungsgaszuleitung stromaufwärts der Leitungstemperiereinrichtung angeordnet ist, und mit einem mittels einer Gaseinlasstemperiereinrichtung auf eine Gaseinlasstemperatur temperierbaren Gaseinlassorgan, das mit der ersten Transportleitung leitungsverbunden ist, wobei eine weitere Verdünnungsgaszuleitung stromaufwärts der Gaseinlasstemperiereinrichtung in das Gaseinlassorgan mündet zur Einspeisung eines Verdünnungsgasstroms in das Gaseinlassorgan, mit dem der gasförmige Ausgangsstoff in eine Prozesskammer einspeisbar ist, die einen Suszeptor aufweist, der mittels einer Suszeptortemperiereinrichtung derart auf eine Suszeptortemperatur temperierbar ist, dass auf dem auf dem Suszeptor aufliegenden Substrat mittels des gasförmigen Ausgangsstoffes eine Schicht aufwächst, und eine Steuereinrichtung, die so eingerichtet ist, dass die Quellentemperiereinrichtung auf die Quellentemperatur, die Leitungstemperiereinrichtung auf die Leitungstemperatur, die Gaseinlasstemperiereinrichtung auf die Gaseinlasstemperatur und die Suszeptortemperiereinrichtung auf die Suszeptortemperatur temperiert.

Aus der US 2008/0241381 A1 ist eine Vorrichtung zum Abscheiden von Metallen bekannt, bei der in einer Quelle Metallcarbonyle auf eine Verdampfungstemperatur aufgeheizt werden. Mittels eines Trägergases werden die Metallcarbonyle durch eine beheizte Gasleitung in ein Gaseinlassorgan einer Prozesskammer eingespeist, in die zusätzlich ein Verdünnungsgas eingespeist wird. Auf einem Substrat, dessen Temperatur höher ist als die Quellentemperatur soll durch thermische Zerlegung der Metallcarbonyle ein Metall abgeschieden werden.

Die WO 01/61071 A2 beschreibt eine Vorrichtung und ein Verfahren zum Kondensationsbeschichten. Flüssige, in einem Vorratsbehälter bevorratete Ausgangsstoffe werden durch Wärmezufuhr verdampft. Der Dampf wird in Gasleitungen, die wärmer sind als die Quellen zu einem Gaseinlassorgan geleitet, aus dem die Ausgangsstoffe in eine Prozesskammer strömen, in der sich ein Substrat befindet, auf dem der Ausgangsstoff kondensieren soll.

Die EP 0 849 375 A2 beschreibt ein Verfahren und eine Vorrichtung zum Verdampfen eines flüssigen Ausgangsstoffes. Dieser wird mit einer Pumpe aus einem Vorratsbehälter gefördert und anschließend durch Wärmezufuhr verdampft.

Eine Vorrichtung zum Verdampfen eines festen Ausgangsstoffs beschreibt die WO 2012/175128. Es handelt sich um einen organischen Ausgangsstoff, der in einer beheizbaren Prozessgasquelle in einem porösen Speicher bevorratet wird. Durch den porösen Speicher wird ein Trägergasstrom hindurchgeleitet. Der Speicher wird beheizt, so dass der feste Ausgangsstoff verdampft. Der so entstandene gasförmige Ausgangsstoff wird in eine Prozesskammer eines Reaktors gebracht, die einen Suszeptor aufweist, auf dem ein Substrat liegt, auf dem der gasförmige Ausgangsstoff kondensiert.

Die DE 10 212 923 A1 beschreibt ein Verfahren zum Beschichten eines Substrates und eine dazugehörige Vorrichtung, wobei Prozessgasquellen vorgesehen sind, die jeweils einen Behälter aufweisen, der jeweils einen pulverförmigen Ausgangsstoff beinhaltet. Durch Hinzufuhr von Wärme wird der pulverförmige Ausgangsstoff in einen gasförmigen Ausgangsstoff gewandelt, der mittels eines Trägergases in eine Prozesskammer transportiert wird.

Die WO 01/61071 A2 beschreibt ein Kondensationsbeschichtungsverfahren, bei dem eine Prozessgasquelle vorgesehen ist, die durch Hinzufuhr von Wärme einen gasförmigen Ausgangsstoff liefert, der mittels eines Trägergases zu einem Gaseinlassorgan eines Reaktors transportiert wird. Dies erfolgt mittels einer Transportleitung, in die eine Verdünnungsgaszuleitung mündet.

Bei einem gattungsgemäßen Verfahren bzw. einer gattungsgemäßen Vorrichtung wird mittels einer Prozessgasquelle ein gasförmiger Ausgangsstoff bereitgestellt, dessen Kondensationstemperatur deutlich höher ist als Raumtemperatur. Dies hat nicht nur zur Folge, dass die gesamte Transportleitung vom Verdampfer bis zum Gaseinlassorgan beheizt werden muss. Auch das Gaseinlassorgan muss derart beheizt werden, dass im Gaseinlassorgan keine Kondensation des Ausgangsstoffes stattfindet. Das Gaseinlassorgan bildet die Decke einer Prozesskammer. Es besitzt eine Gasaustrittsfläche mit einer Vielzahl von Gasaustrittsöffnungen, durch die das vom Trägergas transportierte Prozessgas in die Prozesskammer strömt. Nur in einem geringen Abstand unterhalb der Austrittsfläche befindet sich die Oberseite des Suszeptors, auf der ein oder mehrere Substrate aufliegen. Auf den Oberseiten der Substrate soll eine Schicht aus dem verdampften organischen Material abgeschieden werden. Dies erfolgt durch Kondensation. Die Oberfläche des Substrates muss somit auf einer verhältnismäßig tiefen Temperatur liegen. Hierzu wird der Suszeptor, auf dem die Substrate aufliegen, aktiv gekühlt. Die Gasaustrittsfläche führt durch Wärmestrahlung, aber auch durch Wärmeleitung der Substratoberfläche Wärme zu. Diese Wärme muss durch Aufrechterhaltung eines Temperaturgradienten von der Substratoberfläche zur Kühleinrichtung des Suszeptors abgeführt werden. Dies ist nur durch Aufbringung externer Leistung möglich.

Der Erfindung liegt die Aufgabe zugrunde, Maßnahmen anzugeben, mit denen die Kühlleistung der Suszeptorkühlung verminderbar ist.

Gelöst wird die Aufgabe durch die in den Ansprüchen angegebene Erfindung, wobei jeder Anspruch eine eigenständige Lösung der Aufgabe darstellt.

Die erste Verdünnungsgasleitung ist stromaufwärts der Leitungstemperiereinrichtung angeordnet. Ferner mündet eine weitere Verdünnungsgasleitung stromaufwärts der Gaseinlasstemperiereinrichtung in das Gaseinlassorgan. Durch die Verdünnungsgaszuleitungen werden Inertgasströme in die Leitungsverbindung zwischen Prozessgasquelle und Gaseinlassorgan eingebracht. Bei dem Verdünnungsgas handelt es sich bevorzugt um dasselbe Gas, das auch das Trägergas bildet, bspw. ein Inertgas wie Argon, Stickstoff oder Wasserstoff. Es erfolgt somit zumindest eine zweistufige Verdünnung des gasförmigen Ausgangsstoffes auf dem Transportweg vom Verdampfer zum Gaseinlassorgan. Eine stetige oder schrittweise Verdünnung bildet die Voraussetzung, dass die Leitungstemperatur der Gastransportleitung vom Verdampfer zum Gaseinlassorgan schrittweise ggf. auch kontinuierlich abgesenkt werden kann. Es ist deshalb vorgesehen, dass die Quellentemperatur größer ist als die Leitungstemperatur, die Leitungstemperatur wiederum größer ist als die Gaseinlasstemperatur und die Gaseinlasstemperatur wiederum größer ist als die Suszeptortemperatur.

Die erfindungsgemäße Vorrichtung besitzt eine Steuereinrichtung, mit der die Quellentemperiereinrichtung auf die Quellentemperatur, die Leitungstemperiereinrichtung auf die Leitungstemperatur, die Gaseinlasstemperiereinrichtung auf die Gaseinlasstemperatur und die Suszeptortemperiereinrichtung auf die Suszeptortemperatur geregelt werden. Als Folge dieser Vorrichtungsausgestaltung bzw. Verfahrensführung ist der Temperaturunterschied zwischen Gasaustrittsfläche des Gaseinlassorgans und der zur Gasaustrittsfläche gewandten Oberseite der Substrate geringer als beim Stand der Technik. Als Folge dessen wird weniger Wärme vom Gaseinlassorgan zum Suszeptor transportiert. Die Kühlleistung des Suszeptors ist geringer. Dies hat auch zur Folge, dass ein vertikaler Temperaturgradient innerhalb des Substrates geringer ist als beim Stand der Technik. In einer Weiterbildung der Erfindung ist vorgesehen, dass zwei oder mehr Prozessgasquellen vorgesehen sind. Jede der zwei oder mehreren Prozessgasquellen besitzt einen Verdampfer, in dem ein fester oder flüssiger Ausgangsstoff durch Zufuhr von Wärme in einen gasförmigen Ausgangsstoff verdampft wird. Hierzu wird dem Verdampfer Wärme zugeführt. Jeder Verdampfer besitzt eine Quellentemperiereinrichtung zur Erzeugung der Verdampfungswärme. Jede der Quellen wird auf einer Quellentemperatur gehalten. Die beiden Quellentemperaturen können voneinander verschieden sein. Ebenso können die Ausgangsstoffe voneinander verschieden sein. Die zwei oder mehreren Verdampfer sind jeweils über Transportleitungen mit einem Mischer verbunden. Jede der Transportleitungen besitzt eine Leitungstemperiereinrichtung, die auf eine Leitungstemperatur temperierbar ist. In jeder Transportleitung wird stromaufwärts der Leitungstemperiereinrichtung ein Verdünnungsgasstrom eingespeist. Diese Gasmischungen werden in eine Mischeinrichtung eingespeist. Die Mischeinrichtung besitzt eine Mischerheizeinrichtung, mit der die Mischeinrichtung auf eine Mischertemperatur temperiert wird. Die Mischertemperatur ist geringer als jede der Leitungstemperaturen. Die Mischertemperatur ist aber größer als die Gaseinlasstemperatur. In einer Weiterbildung der Erfindung ist vorgesehen, dass die Mischeinrichtung über eine weitere, insbesondere eine dritte Transportleitung mit dem Gaseinlassorgan leitungsverbunden ist. Diese dritte Transportleitung besitzt ebenfalls eine Leitungstemperiereinrichtung, die auf eine Leitungstemperatur, insbesondere eine dritte Leitungstemperatur, temperierbar ist. Stromaufwärts der dritten Leitungstemperiereinrichtung mündet eine weitere Verdünnungsgaszuleitung in die dritte Transportleitung, durch die ein Verdünnungsgasstrom in die Transportleitung eingespeist wird. Die dritte Leitungstemperatur liegt zwischen der Mischertemperatur und der Gaseinlasstemperatur. Zufolge der erfindungsgemäßen Verfahrensführung in einer erfindungsgemäßen Vorrichtung wird die Temperatur des stetig bzw. schrittweise verdünnten Prozessgasstroms stetig bzw. schrittweise vom Verdampfer bis zur Gasauslassfläche des Gaseinlassorgans abgesenkt. Dies ist möglich, weil der Partialdruck des gasförmigen Ausgangsstoffs im Gasstrom als Folge der Verdünnung schrittweise bzw. stetig abgesenkt wird. Gleichwohl liegt an jeder Stelle des Gasleitungssystems zwischen Verdampfer und Gasaustrittsöffnung des Gaseinlassorgans die Temperatur des Gasstroms oberhalb des Kondensationspunktes des gasförmigen Ausgangsstoffs.

Ein Ausführungsbeispiel der Erfindung wird nachfolgend anhand beigefügter Zeichnungen erläutert. Es zeigen:
- Fig. 1: eine schematische Darstellung einer erfindungsgemäßen Vorrichtung,
- Fig. 2: schematisch den Temperaturverlauf innerhalb des Gasleitungssystems vom Verdampfer 1 zum Suszeptor 35 und
- Fig. 3: schematisch das Steuerungswerk der Vorrichtung.

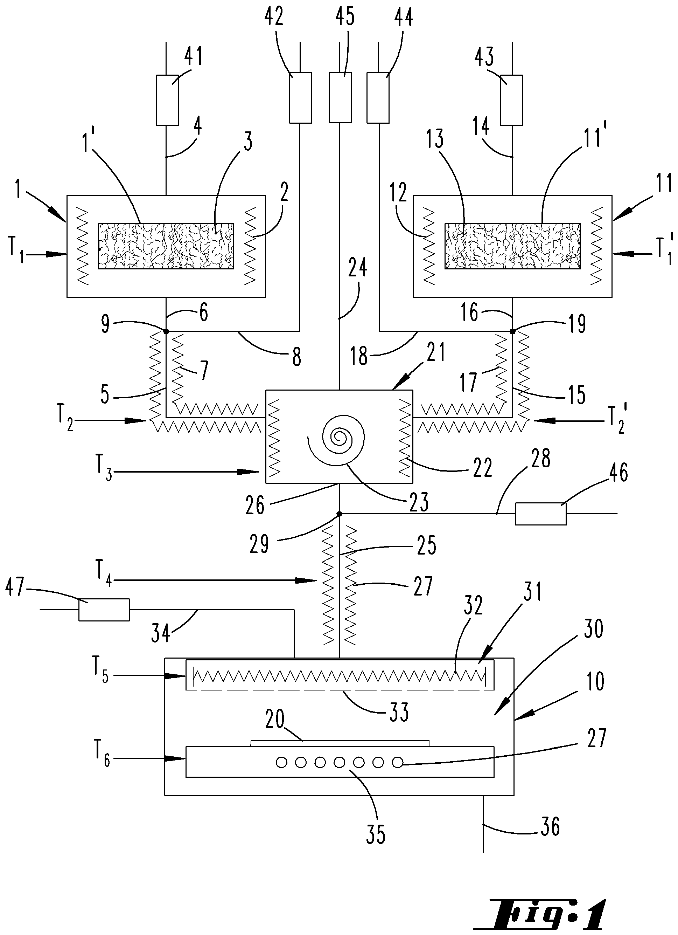

Die in der Figur 1 lediglich schematisch dargestellte Vorrichtung besitzt einen Reaktor 10, bei dem es sich um ein gasdicht nach außen abgeschlossenes Gehäuse handelt. Das Gehäuse ist mittels einer Ableitung 36, die an eine Pumpe angeschlossen ist, evakuierbar. Innerhalb des Reaktors 10 befindet sich ein aus Metall bestehender Suszeptor 35, in dem Kühlkanäle 27 angeordnet sind, mit denen die Oberseite des als Kühlblock ausgestalteten Suszeptors 35 auf eine Suszeptortemperatur T₆ von -50 bis 10°C temperierbar ist. Die Oberseite des Suszeptors 35 bildet den Boden einer Prozesskammer 30, auf dem ein oder mehrere Substrate 20 angeordnet sind. Die Decke der Prozesskammer 30 wird von einer Gasaustrittsfläche eines Gaseinlassorganes 31 ausgebildet. Die Gasaustrittsfläche des Gaseinlassorganes 31 besitzt eine Vielzahl von siebartig und gleichmäßig über die gesamte Gasaustrittsfläche verteilten Gasaustrittsöffnungen 33, aus denen ein Prozessgas in die Prozesskammer 30 einströmen kann. Das Gaseinlassorgan 31 kann duschkopfartig ausgebildet sein.

Das Prozessgas beinhaltet einen gasförmigen Ausgangsstoff, der mit einer Temperatur T₅, die oberhalb seines Kondensationspunktes liegt, in die Prozesskammer 30 eingespeist wird. Die Temperatur der Oberfläche des Substrates 20 ist niedriger als die Kondensationstemperatur des gasförmigen Ausgangsstoffes, so dass der gasförmige Ausgangsstoff auf der Oberseite des Substrates 20 als Schicht kondensiert.

Innerhalb des Gaseinlassorganes 31 ist eine Temperiereinrichtung 32 vorgesehen. Mit dieser Temperiereinrichtung 32, die beim Ausführungsbeispiel als Heizung ausgebildet ist, wird der gasförmige Ausgangsstoff auf die Temperatur T₅ (Gaseinlasstemperatur) temperiert.

Die Vorrichtung besitzt zumindest einen Quelle 1, in der ein fester oder flüssiger Ausgangsstoff 3 bereitgehalten wird. Der Ausgangsstoff 3 wird auf einer Quellentemperatur T₁ gehalten, die größer ist als die Gaseinlasstemperatur T₅. Der Ausgangsstoff 3 kann als poröser Körper, als Pulver oder dergleichen bevorratet sein. Der Ausgangsstoff kann aber auch eine Belegung auf einem porösen Körper sein. Es ist eine Quellentemperiereinrichtung 2 vorgesehen, bei der es sich um eine Heizung handelt. Mit der Heizung wird stetig Wärme in einen Verdampfer 1' eingespeist, der den Ausgangsstoff 3 beinhaltet, so dass der Ausgangsstoff 3 in die Gasform gebracht wird. Anstelle eines festen Ausgangsstoffes kann aber auch ein flüssiger Ausgangsstoff verwendet werden.

In den Verdampfer 1' mündet eine Trägergaszuleitung 4. Mittels eines Massenflusscontrolers 41 wird ein Trägergasstrom in den Verdampfer 1' eingespeist. Es handelt sich dabei um Argon, Stickstoff, Wasserstoff oder ein anderes Inertgas. Der in die Gasform gewandelte Ausgangsstoff 3 wird durch einen Gasaustritt 6 aus dem Verdampfer 1' transportiert. Der Gausaustritt 6 ist mit einer Transportleitung 5 verbunden, so dass der gasförmige Ausgangsstoff aus dem Gasaustritt 6 in die Transportleitung 5 eingespeist werden kann. Unmittelbar stromabwärts des Gasaustritts 6 mündet eine Verdünnungszuleitung 8 in die sich daran anschließende Transportleitung 5. Durch die Verdünnungsgasleitung 8 wird ein Verdünnungsgas in die Gasleitung eingespeist. Der Massenfluss des in die Trägergaszuleitung eingespeisten Gases und der Massenfluss des in die Verdünnungsgasleitung 8 eingespeisten Gases wird durch Massenflusscontroler 41, 42 geregelt. Der den gasförmigen Ausgangsstoff transportierende Trägergasstrom mischt sich somit an der Einspeisestelle 9 mit dem Verdünnungsgasstrom, wobei es sich bei dem Verdünnungsgas um dasselbe Gas handelt, das auch den Trägergasstrom bildet.

Die sich an die Einspeisestelle 9 anschließende Transportleitung 5 wird von einer Heizeinrichtung 7 beheizt. Diese Leitungstemperiereinrichtung 7 ist als Heizmanschette ausgebildet. Sie heizt die Transportleitung 5 auf eine Transportleitungstemperatur T₂, die geringer ist als die Quellentemperatur Z₁.

Beim Ausführungsbeispiel ist eine zweite Prozessgasquelle 11 vorgesehen, die einen zweiten Verdampfer 11' aufweist, der ebenfalls mit einer Heizeinrichtung 12 versehen ist, mit der ein flüssiger oder fester Ausgangsstoff 13 auf eine zweite Quellentemperatur T₁' temperiert wird. Auch hier mündet in den Verdampfer 11' eine Zuleitung 14, durch die ein mittels Massenflussmesser 43 kontrollierter Trägergasstrom in den Verdampfer 11' eingespeist wird. Das Trägergas transportiert den verdampften Ausgangsstoff durch einen Gasaustritt 16 aus dem Verdampfer 11' heraus.

An einer Einspeisestelle 19 wird in den Gasstrom ein Verdünnungsgas eingespeist. Dies erfolgt mittels einer Verdünnungsgaszuleitung 18, durch die ein von einem Massenflusscontroler 44 gesteuerter Massenfluss eines Verdünnungsgases eingespeist wird.

Stromabwärts der Einspeisestelle 19 erstreckt sich eine Transportleitung 15, die von einer Heizmanschette umgeben ist, die eine Leitungsheizung 17 ausbildet, mit der die Transportleitung 15 auf einer Leitungstemperatur T₂' gehalten wird. Die Leitungstemperatur T₂' ist geringer als die Qellentemperatur T₁'. Der Ausgangsstoff 13 sind verschiedene organische Materialien.

Die Transportleitung 5 und die Transportleitung 15 münden in eine Mischeinrichtung 21, in der Gasumlenkelemente 23 angeordnet sind, um die aus den Transportleitungen 5,15 in die Mischeinrichtung 21 eintretenden Gasmischungen miteinander zu vermischen.

Innerhalb der Mischeinrichtung 21 ist eine Mischertemperiereinrichtung 22 vorgesehen. Es handelt sich hier um eine Heizeinrichtung, mit der die Mischeinrichtung 21 und insbesondere die Gasumlenkelemente 23 auf einer Mischertemperatur T₃ gehalten werden. Die Mischertemperatur T₃ ist geringer als die Leitungstemperaturen T₂, T₂'. Um zu vermeiden, dass der gasförmige Ausgangsstoff an den Gasumlenkflächen 23 kondensiert, wird das in die Mischeinrichtung 21 eintretende Gasgemisch, bestehend aus Trägergas und gasförmigem Ausgangsstoff, weiter verdünnt. Hierzu mündet stromaufwärts der Gasumlenkelemente 23 und insbesondere stromaufwärts der Heizeinrichtung 22 eine weitere Verdünnungsgaszuleitung 24 in die Mischkammer des Mischers 21. Der Verdünnungsgasstrom, der durch die Verdünnungsgaszuleitung 24 in die Mischkammer eingespeist wird, wird von einem Massenflusscontroler 45 gesteuert.

Das in der Mischeinrichtung 21 gemischte Gasgemisch tritt durch einen Gasaustritt 26 aus der Mischeinrichtung 21 heraus. Dort befindet sich eine weitere Einspeisestelle 29, an der eine weitere Verdünnungsgaszuleitung 28 in den Gasstrom mündet. Durch die Verdünnungsgasleitung 28 wird ein weiterer Verdünnungsgasstrom, der von einem Massenflussregler 46 gesteuert ist, in den Gasstrom geleitet. Die Einspeisestelle 29 befindet sich unmittelbar stromabwärts des Gasaustritts 26.

Die sich stromabwärts der Einspeisestelle 29 erstreckende Transportleitung 25 wird von einer Heizmanschette 27 auf eine Leitungstemperatur T₄ aufgeheizt, die geringer ist als die Mischertemperatur T₃ und größer ist als die Temperatur T₅ innerhalb des Gaseinlassorgans 31.

Die Transportleitung 25 mündet in das Gaseinlassorgan 31, in dem sich eine Heizeinrichtung 32 befindet. Stromaufwärts der Heizeinrichtung 32 mündet eine Verdünnungsgaszuleitung 34 in das Gaseinlassorgan 31, durch die ein weiterer Verdünnungsgasstrom, der von einem Massenflussregler 47 gesteuert ist, in das Gaseinlassorgan 31 eingespeist wird. Der in das Gaseinlassorgan 31 eingespeiste Gasstrom wird dadurch stromaufwärts der Heizeinrichtung 32 weiter verdünnt.

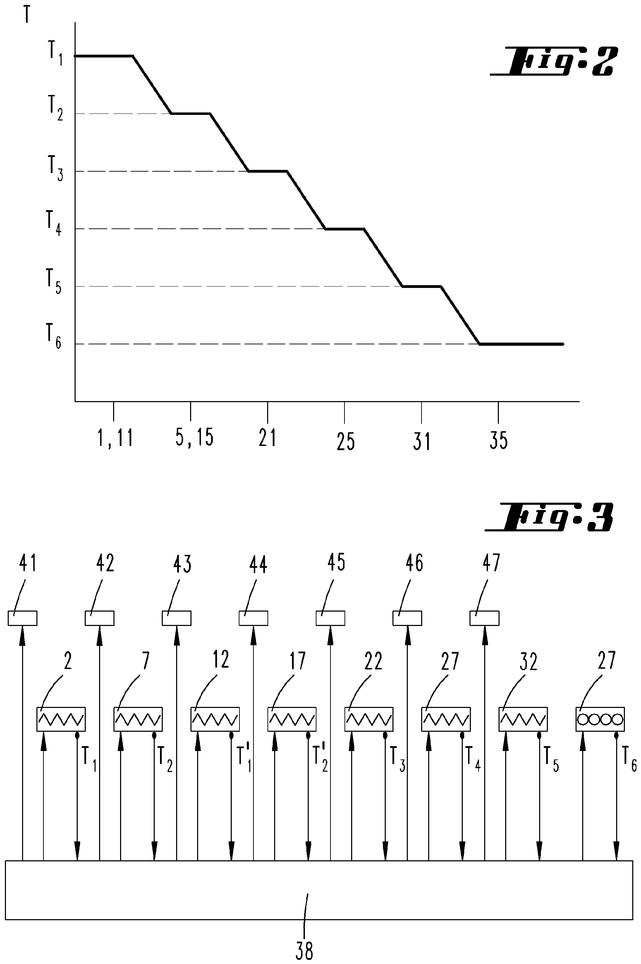

Die schrittweise Verdünnung des gasförmigen Ausgangsstoffs in der Gasleitung zwischen Quelle 1, 11 bzw. Verdampfer 1', 11' und Gaseinlassorgan 31 führt zu einer schrittweisen Verminderung des Partialdrucks des gasförmigen Ausgangsstoffs bzw. der gasförmigen Ausgangsstoffe innerhalb des Gasleitungssystems in Strömungsrichtung. Dies ermöglicht den oben geschilderten Temperaturverlauf im Gastransportsystem, wie er in der Figur 2 dargestellt ist, aus der hervorgeht, dass die Temperatur zwischen Quelle 1, 11 bzw. Verdampfer 1', Verdampfer 11' und Suszeptor 35 schrittweise absinkt, wobei der Temperaturverlauf in der Figur 2 lediglich qualitativ dargestellt ist. Der Temperaturunterschied zwischen den Temperaturen T₅ und T₆ kann größer sein als die übrigen Temperaturschritte.

Die Figur 3 verdeutlicht die Steuerung. Die Vorrichtung besitzt eine Steuereinrichtung 38, mit der die Temperaturen T₁, T₂, T₁', T₂', T₃, T₄, T₅ und T₆ eingestellt werden können. Dies erfolgt mittels Reglern und Steuergliedern, die die Heizeinrichtungen 2, 7, 12, 17, 22, 27, 32 mit Heizleistung versorgen. Die Temperaturen T₁, T₂, T₁', T₂', T₃, T₄, T₅ und T₆ werden mittels Thermoelementen gemessen und der Steuereinrichtung 38 zur Regelung zur Verfügung gestellt. Die Steuereinrichtung versorgt die Kühleinrichtung 27 mit Kühlleistung. Ferner ist die Steuereinrichtung in der Lage, die Massenflusscontroler 41 - 47 anzusteuern, mit denen die Trägergasflüsse bzw. Verdünnungsgasflüsse geregelt werden.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:
Eine Vorrichtung, die dadurch gekennzeichnet ist, dass die erste Verdünnungsgaszuleitung 8, 18 stromaufwärts der Leitungstemperiereinrichtung 7, 17 angeordnet ist und eine weitere Verdünnungsgaszuleitung 34 stromaufwärts der Gaseinlasstemperiereinrichtung 32 in das Gaseinlassorgan 31 mündet zur Einspeisung eines Verdünnungsgasstroms in das Gaseinlassorgan 31.

Eine Vorrichtung, die gekennzeichnet ist durch eine Steuereinrichtung, die so eingerichtet ist, dass die Quellentemperiereinrichtung 2, 12 auf die Quellentemperatur T₁, T₁', die Leitungstemperiereinrichtung 7, 17 auf die Leitungstemperatur T₂, T₂', die Gaseinlasstemperiereinrichtung 32 auf die Gaseinlasstemperatur T₅ und die Suszeptortemperiereinrichtung 27 auf die Suszeptortemperatur T6 temperierbar sind.

Ein Verfahren, das dadurch gekennzeichnet ist, dass die erste Verdünnungsgaszuleitung 8, 18 stromaufwärts der Leitungstemperiereinrichtung 7,17 angeordnet ist und durch eine weitere Verdünnungsgaszuleitung 34, die stromaufwärts der Gaseinlasstemperiereinrichtung 32 in das Gaseinlassorgan 31 mündet, ein Verdünnungsgasstrom in das Gaseinlassorgan 31 eingespeist wird.

Eine Vorrichtung, die dadurch gekennzeichnet ist, dass die erste Quellentemperatur T₁, T₁' größer ist als die Leitungstemperatur T₂, T₂', die Leitungstemperatur T₂, T₂' größer ist als die Gaseinlasstemperatur T₅ und die Gaseinlasstemperatur T₅ größer ist als die eine Suszeptortemperatur T₆

Eine Vorrichtung, die gekennzeichnet ist durch eine einen zweiten Verdampfer 11' aufweisende Prozessgasquelle, in welchem zweiten Verdampfer 11' ein fester oder flüssiger zweiter Ausgangsstoff durch Zufuhr von mit einer zweiten Quellentemperiereinrichtung 12 erzeugten Wärme bei einer zweiten Quellentemperatur T₁' in einen zweiten gasförmigen Ausgangsstoff verdampfbar ist, wobei in den zweiten Verdampfer 11' eine zweite Trägergaszuleitung 14 mündet zur Einspeisung eines zweiten Trägergasstroms zum Transport des zweiten gasförmigen Ausgangsstoffs aus dem zweiten Verdampfer 11' in eine zweite Transportleitung 15, wobei die zweite Transportleitung 15 mit einer zweiten Leitungstemperiereinrichtung 17 auf eine zweite Leitungstemperatur T₂' temperiert wird und in die zweite Transportleitung 15 eine zweite Verdünnungsgaszuleitung 18 mündet, durch die ein zweiter Verdünnungsgasstrom in die zweite Transportleitung 18 eingespeist wird, wobei die erste Transportleitung 8 und die zweite Transportleitung 18 in einen Mischer 21 münden, der mittels einer Mischertemperiereinrichtung 22 auf eine Mischertemperatur T₃ temperiert wird, wobei stromaufwärts der Mischertemperiereinrichtung 22 eine Verdünnungsgaszuleitung 24 in die Mischeinrichtung 21 mündet, mit der ein Verdünnungsgasstrom in die Mischeinrichtung 21 eingespeist wird.

Ein Verfahren, das gekennzeichnet ist durch eine einen zweiten Verdampfer 11' aufweisende Prozessgasquelle, in welchem zweiten Verdampfer 11' ein fester oder flüssiger zweiter Ausgangsstoff durch Zufuhr von mit einer zweiten Quellentemperiereinrichtung 12 erzeugten Wärme bei einer zweiten Quellentemperatur T₁' in einen zweiten gasförmigen Ausgangsstoff verdampft wird, wobei in den zweiten Verdampfer 11' eine zweite Trägergaszuleitung 14 mündet, in die ein zweiter Trägergasstrom eingespeist wird, mit dem der zweite gasförmige Ausgangsstoff aus dem zweiten Verdampfer 11' in eine zweite Transportleitung 15 transportiert wird, wobei die zweite Transportleitung 15 mit einer zweiten Leitungstemperiereinrichtung 17 auf eine zweite Leitungstemperatur T₂' temperiert wird und in die zweite Transportleitung 15 eine zweite Verdünnungsgaszuleitung 18 mündet, durch die ein zweiter Verdünnungsgasstrom in die zweite Transportleitung 18 eingespeist wird, wobei die erste Transportleitung 8 und die zweite Transportleitung 18 in einen Mischer 21 münden, der mittels einer Mischertemperiereinrichtung 22 auf eine Mischertemperatur T₃ temperiert wird, wobei stromaufwärts der Mischertemperiereinrichtung 22 eine Verdünnungsgaszuleitung 24 in die Mischeinrichtung 21 mündet, mit der ein Verdünnungsgasstrom in die Mischeinrichtung 21 eingespeist wird.

Eine Vorrichtung, die dadurch gekennzeichnet ist, dass die Mischertemperatur T₃ geringer ist als die erste und die zweite Leitungstemperatur T₂, T₂' und größer ist als die Gaseinlasstemperatur T₅.

Eine Vorrichtung, die gekennzeichnet ist durch einen stromabwärts der Mischeinrichtung 21 und stromaufwärts des Gaseinlassorgans 31 angeordnete Transportleitung 25 zum Transport des gasförmigen Ausgangsstoffs von der Mischeinrichtung 21 in das Gaseinlassorgan 31, welche mittels einer Leitungstemperiereinrichtung 27 auf eine Leitungstemperatur T₄ temperierbar ist, wobei stromaufwärts der Leitungstemperiereinrichtung 27 eine Verdünnungsgaszuleitung 28 in die Transportleitung 25 mündet zur Einspeisung eines Verdünnungsgasstroms in die Transportleitung 25.

Ein Verfahren, das gekennzeichnet ist durch einen stromabwärts der Mischeinrichtung 21 und stromaufwärts des Gaseinlassorgans 31 angeordnete Transportleitung 25 durch die der gasförmige Ausgangsstoff von der Mischeinrichtung 21 in das Gaseinlassorgan 31 transportiert wird, welche mittels einer Leitungstemperiereinrichtung 27 auf eine Leitungstemperatur T₄ temperiert wird, wobei stromaufwärts der Leitungstemperiereinrichtung 27 eine Verdünnungsgaszuleitung 28 in die Transportleitung 25 mündet, mit der ein Verdünnungsgasstrom in die Transportleitung 25 eingespeist wird.

Eine Vorrichtung, die dadurch gekennzeichnet ist, dass die Mischertemperatur T₃ größer ist als die Leitungstemperatur T₄ und die Leitungstemperatur T₄ größer ist als die Gaseinlasstemperatur T₅.

Ein Verfahren, das dadurch gekennzeichnet ist, dass durch Einspeisen von einer Vielzahl von Verdünnungsgasströmen an verschiedenen, voneinander in Strömungsrichtung beabstandeten Stellen in eine beheizte Leitungsverbindung zwischen Verdampfer 1', 11' und Gaseinlassorgan 31 der Partialdruck des gasförmigen Ausgangsstoffes im Trägergasstrom schrittweise vermindert wird, wobei die Leitungsverbindung derart beheizt wird, dass an jeder Stelle der Leitungsverbindung die Temperatur im Gasstrom größer ist als die Kondensationstemperatur des gasförmigen Ausgangsstoffs.

**Bezugszeichenliste:**

| | | | | |
|---|---|---|---|---|
| 1 | Prozess gas quelle | 26 | Gasaustritt | |
| 1' | Verdampfer | 27 | Temperiereinrichtung, Kühleinrichtung T₄ | |
| 2 | Heizeinrichtung T₁ | 28 | Zuleitung | |
| 3 | Ausgangsstoff | 29 | Einspeisestelle | |
| 4 | Zuleitung 1 | 30 | Prozesskammer | |
| 5 | Transportleitung | 31 | Gaseinlassorgan | |
| 6 | Gasaustritt | 32 | Heizeinrichtung T₅ | |
| 7 | Heizeinrichtung T₂ | 33 | Gasaustrittsöffnung | |
| 8 | Zuleitung | 34 | Zuleitung 5 | |
| 9 | Einspeisestelle | 35 | Suszeptor | |
| 10 | CVD-Reaktor | 36 | Ableitung | |
| 11 | Prozessgasquelle | 37 | Kühleinrichtung T₆ | |
| 11' | Verdampfer | 38 | Steuereinrichtung | |
| 12 | Heizeinrichtung T₁' | 39 | -------------- | |
| 13 | Ausgangsstoff | 40 | -------------- | |
| 14 | Zuleitung | 41 | Massenflusscontroler | Zul. 1 |
| 15 | Transportleitung | 42 | Massenflusscontroler | Zul. 2 |
| 16 | Gasaustritt | 43 | Massenflusscontroler | Zul. 1 |
| 17 | Heizeinrichtung T₂' | 44 | Massenflusscontroler | Zul. 2 |
| 18 | Zuleitung | 45 | Massenflusscontroler | Zul. 3 |
| 19 | Einspeisestelle | 46 | Massenflusscontroler | Zul. 4 |
| 20 | Substrat | 47 | Massenflusscontroler | Zul. 5 |
| 21 | Mischeinrichtung | | | |
| 22 | Heizeinrichtung T₃ | T₁ | Quellentemperatur | |
| 23 | Gaseinlasselement | T₂ | Leitungstemperatur | |
| 24 | Zuleitung 3 | T₃ | Mischertemperatur | |
| 25 | Transportleitung | T₄ | Leitungstemperatur | |
| T₅ | Gaseintrittstemperatur | | | |
| T₆ | Depositionstemperatur | | | |
| Z₁ | Quellentemperatur | | | |

## Patentansprüche

1. Vorrichtung zum Abscheiden ein oder mehrerer Schichten auf einem Substrat (20), mit einer einen Verdampfer (1', 11') aufweisenden Prozessgasquelle (1, 11), in welchem Verdampfer (1', 11') ein fester oder flüssiger Ausgangsstoff durch Zufuhr von mit einer Quellentemperiereinrichtung (2, 12) erzeugten Wärme bei einer Quellentemperatur (T₁, T₁') in einen gasförmigen Ausgangsstoff verdampfbar ist, wobei in den Verdampfer (1', 11') eine Trägergaszuleitung (4, 14) mündet, zur Einspeisung eines Trägergasstroms zum Transport des gasförmigen Ausgangsstoffs aus dem Verdampfer (1', 11') in eine erste Transportleitung (5, 15), wobei die erste Transportleitung (5,15) mit einer Leitungstemperiereinrichtung (7, 17) auf eine Leitungstemperatur (T₂, T₂') temperierbar ist, und in die erste Transportleitung (5,15) eine erste Verdünnungsgaszuleitung (8, 18) mündet, zur Einspeisung eines Verdünnungsgasstroms in die erste Transportleitung (5, 15), wobei die erste Verdünnungsgaszuleitung (8, 18) stromaufwärts der Leitungstemperiereinrichtung (7, 17) angeordnet ist, und mit einem mittels einer Gaseinlasstemperiereinrichtung (32) auf eine Gaseinlasstemperatur (T₅) temperierbaren Gaseinlassorgan (31), das mit der ersten Transportleitung (8 ,18) leitungsverbunden ist, wobei eine weitere Verdünnungsgaszuleitung (34) stromaufwärts der Gaseinlasstemperiereinrichtung (32) in das Gaseinlassorgan (31) mündet zur Einspeisung eines Verdünnungsgasstroms in das Gaseinlassorgan (31), mit dem der gasförmige Ausgangsstoff in eine Prozesskammer (30) einspeisbar ist, die einen Suszeptor (35) aufweist, der mittels einer Suszeptortemperiereinrichtung (27) derart auf eine Suszeptortemperatur (T₆) temperierbar ist, dass auf dem auf dem Suszeptor (35) aufliegenden Substrat (20) mittels des gasförmigen Ausgangsstoffes eine Schicht aufwächst, und eine Steuereinrichtung, die Quellentemperiereinrichtung (2, 12) auf die Quellentemperatur (T₁, T₁'), die Leitungstemperiereinrichtung (7, 17) auf die Leitungstemperatur (T₂, T₂'), die Gaseinlasstemperiereinrichtung (32) auf die Gaseinlasstemperatur (T₅) und die Suszeptortemperiereinrichtung (27) auf die Suszeptortemperatur (T6) temperiert, **dadurch gekennzeichnet, dass** die Steuereinrichtung so eingerichtet ist, dass beim Abscheiden der Schicht die Quellentemperatur (T₁, T₁') größer ist als die Leitungstemperatur (T₂, T₂), die Leitungstemperatur (T₂, T₂') größer ist als die Gaseinlasstemperatur (T₅) und die Gaseinlasstemperatur (T₅) größer ist als die eine Suszeptortemperatur (T₆).

2. Verfahren zum Abscheiden ein oder mehrerer Schichten auf mindestens einem Substrat (20), mit einer einen Verdampfer (1', 11') aufweisenden Prozessgasquelle (1, 11), in welchem Verdampfer (1', 11') ein fester oder flüssiger Ausgangsstoff durch Zufuhr von mit einer Quellentemperiereinrichtung (2 ,12) erzeugten Wärme bei einer Quellentemperatur (T₁, T₁') in einen gasförmigen Ausgangsstoff verdampft wird, wobei in den Verdampfer (1', 11') eine Trägergaszuleitung (4, 14) mündet, in die ein erster Trägergasstrom eingespeist wird, mit dem der gasförmige Ausgangsstoff aus dem Verdampfer (1', 11') in eine erste Transportleitung (5, 15) transportiert wird, wobei die erste Transportleitung (5, 15) mit einer Leitungstemperiereinrichtung (7, 17) auf eine Leitungstemperatur (T₂, T₂') temperiert wird, und in die erste Transportleitung (5, 15) eine erste Verdünnungsgaszuleitung (8, 18) mündet, mit der ein Verdünnungsgasstrom in die erste Transportleitung (5, 15) eingespeist wird, wobei die erste Verdünnungsgaszuleitung (8, 18) stromaufwärts der Leitungstemperiereinrichtung (7, 17) angeordnet ist, und mit einem mittels einer Gaseinlasstemperiereinrichtung (32) auf eine Gaseinlasstemperatur (T₅) temperierten Gaseinlassorgan (31), das mit der ersten Transportleitung (8, 18) leitungsverbunden ist, wobei eine weitere Verdünnungsgaszuleitung (34) stromaufwärts der Gaseinlasstemperiereinrichtung (32) in das Gaseinlassorgan (31) mündet zur Einspeisung eines Verdünnungsgasstroms in das Gaseinlassorgan (31), mit dem der gasförmige Ausgangsstoff in eine Prozesskammer (30) eingespeist wird, die einen Suszeptor (35) aufweist, der mittels einer Suszeptortemperiereinrichtung (27) auf eine Suszeptortemperatur (T₆) temperiert wird, wobei auf dem auf dem Suszeptor (35) aufliegenden mindestens einem Substrat (20) mittels des gasförmigen Ausgangsstoffes eine Schicht abgeschieden wird, **dadurch gekennzeichnet, dass** beim Abscheiden der Schicht die Quellentemperatur (T₁, T₁') größer ist als die Leitungstemperatur (T₂, T2'),die Leitungstemperatur (T₂, T₂') größer ist als die Gaseinlasstemperatur (T₅) und die Gaseinlasstemperatur (T₅) größer ist als die eine Suszeptortemperatur (T₆).

3. Vorrichtung nach Anspruch 1, **gekennzeichnet durch** eine einen zweiten Verdampfer (11') aufweisende Prozessgasquelle, in welchem zweiten Verdampfer (11') ein fester oder flüssiger zweiter Ausgangsstoff durch Zufuhr von mit einer zweiten Quellentemperiereinrichtung (12) erzeugten Wärme bei einer zweiten Quellentemperatur (T₁') in einen zweiten gasförmigen Ausgangsstoff verdampfbar ist, wobei in den zweiten Verdampfer (11') eine zweite Trägergaszuleitung (14) mündet zur Einspeisung eines zweiten Trägergasstroms zum Transport des zweiten gasförmigen Ausgangsstoffs aus dem zweiten Verdampfer (11') in eine zweite Transportleitung (15), wobei die zweite Transportleitung (15) mit einer zweiten Leitungstemperiereinrichtung (17) auf eine zweite Leitungstemperatur (T₂') temperiert wird und in die zweite Transportleitung (15) eine zweite Verdünnungsgaszuleitung (18) mündet, durch die ein zweiter Verdünnungsgasstrom in die zweite Transportleitung (18) eingespeist wird, wobei die erste Transportleitung (8) und die zweite Transportleitung (18) in einen Mischer (21) münden, der mittels einer Mischertemperiereinrichtung (22) auf eine Mischertemperatur (T₃) temperiert wird, wobei stromaufwärts der Mischertemperiereinrichtung (22) eine Verdünnungsgaszuleitung (24) in die Mischeinrichtung (21) mündet, mit der ein Verdünnungsgasstrom in die Mischeinrichtung (21) eingespeist wird.

4. Verfahren nach Anspruch 2, **gekennzeichnet durch** eine einen zweiten Verdampfer (11') aufweisende Prozessgasquelle, in welchem zweiten Verdampfer (11') ein fester oder flüssiger zweiter Ausgangsstoff durch Zufuhr von mit einer zweiten Quellentemperiereinrichtung (12) erzeugten Wärme bei einer zweiten Quellentemperatur (T₁') in einen zweiten gasförmigen Ausgangsstoff verdampft wird, wobei in den zweiten Verdampfer (11') eine zweite Trägergaszuleitung (14) mündet, in die ein zweiter Trägergasstrom eingespeist wird, mit dem der zweite gasförmige Ausgangsstoff aus dem zweiten Verdampfer (11') in eine zweite Transportleitung (15) transportiert wird, wobei die zweite Transportleitung (15) mit einer zweiten Leitungstemperiereinrichtung (17) auf eine zweite Leitungstemperatur (T₂') temperiert wird und in die zweite Transportleitung (15) eine zweite Verdünnungsgaszuleitung (18) mündet, durch die ein zweiter Verdünnungsgasstrom in die zweite Transportleitung (18) eingespeist wird, wobei die erste Transportleitung (8) und die zweite Transportleitung (18) in einen Mischer (21) münden, der mittels einer Mischertemperiereinrichtung (22) auf eine Mischertemperatur (T₃) temperiert wird, wobei stromaufwärts der Mischertemperiereinrichtung (22) eine Verdünnungsgaszuleitung (24) in die Mischeinrichtung (21) mündet, mit der ein Verdünnungsgasstrom in die Mischeinrichtung (21) eingespeist wird.

5. Vorrichtung nach Anspruch 3, **dadurch gekennzeichnet, dass** die Mischertemperatur (T₃) geringer ist als die erste und die zweite Leitungstemperatur (T₂, T₂) und größer ist als die Gaseinlasstemperatur (T₅).

6. Verfahren nach Anspruch 4, **dadurch gekennzeichnet, dass** die Mischertemperatur (T₃) geringer ist als die erste und die zweite Leitungstemperatur (T₂, T₂') und größer ist als die Gaseinlasstemperatur (T₅).

7. Vorrichtung nach Anspruch 3, **gekennzeichnet durch** einen stromabwärts der Mischeinrichtung (21) und stromaufwärts des Gaseinlassorgans (31) angeordnete Transportleitung (25) zum Transport des gasförmigen Ausgangsstoffs von der Mischeinrichtung (21) in das Gaseinlassorgan (31), welche mittels einer Leitungstemperiereinrichtung (27) auf eine Leitungstemperatur (T₄) temperierbar ist, wobei stromaufwärts der Leitungstemperiereinrichtung (27) eine Verdünnungsgaszuleitung (28) in die Transportleitung (25) mündet zur Einspeisung eines Verdünnungsgasstroms in die Transportleitung (25).

8. Verfahren nach Anspruch 4, **gekennzeichnet durch** einen stromabwärts der Mischeinrichtung (21) und stromaufwärts des Gaseinlassorgans (31) angeordnete Transportleitung (25) durch die der gasförmige Ausgangsstoff von der Mischeinrichtung (21) in das Gaseinlassorgan (31) transportiert wird, welche mittels einer Leitungstemperiereinrichtung (27) auf eine Leitungstemperatur (T₄) temperiert wird, wobei stromaufwärts der Leitungstemperiereinrichtung (27) eine Verdünnungsgaszuleitung (28) in die Transportleitung (25) mündet, mit der ein Verdünnungsgasstrom in die Transportleitung (25) eingespeist wird.

9. Vorrichtung nach einem der Ansprüche 3, 5 oder 7, **dadurch gekennzeichnet, dass** die Mischertemperatur (T₃) größer ist als die Leitungstemperatur (T₄) und die Leitungstemperatur (T₄) größer ist als die Gaseinlasstemperatur (T₅).

10. Verfahren nach einem der Ansprüche 4, 6 oder 8, **dadurch gekennzeichnet, dass** die Mischertemperatur (T₃) größer ist als die Leitungstemperatur (T₄) und die Leitungstemperatur (T₄) größer ist als die Gaseinlasstemperatur (T₅).

11. Verfahren nach einem der Ansprüche 2, 4, 6, 8 oder 10, **dadurch gekennzeichnet, dass** durch Einspeisen von einer Vielzahl von Verdünnungsgasströmen an verschiedenen, voneinander in Strömungsrichtung beabstandeten Stellen in eine beheizte Leitungsverbindung zwischen Verdampfer 1', 11') und Gaseinlassorgan (31) der Partialdruck des gasförmigen Ausgangsstoffes im Trägergasstrom schrittweise vermindert wird, wobei die Leitungsverbindung derart beheizt wird, dass an jeder Stelle der Leitungsverbindung die Temperatur im Gasstrom größer ist als die Kondensationstemperatur des gasförmigen Ausgangsstoffs.

12. Vorrichtung nach einem der Ansprüche 1, 3, 5 oder 7, **dadurch gekennzeichnet, dass** die Schichten organische Schichten sind.

13. Verfahren nach einem der Ansprüche 2, 4, 6, 8, 10 oder 11, **dadurch gekennzeichnet, dass** die Schichten organische Schichten sind.

## Claims

1. Device for depositing one or more layers on a substrate (20), said device comprising a process-gas source (1, 11) having an evaporator (1', 11'), in which evaporator (1', 11') a solid or liquid starting material can be evaporated by supplying heat, generated by means (2, 12) for controlling the temperature of a source, at a source temperature (T₁, T₁') into a gaseous starting material, a carrier-gas feed line (4, 14) opening into the evaporator (1', 11') in order to feed a stream of carrier gas in order to transport the gaseous starting material out of the evaporator (1', 11') into a first transport line (5, 15), it being possible to control the temperature of the first transport line (5, 15) to a line temperature (T₂, T₂') using a means (7, 17) for controlling the temperature of the line, and a first dilution-gas supply line (8, 18) opening into the first transport line (5, 15) in order to feed a stream of dilution gas into the first transport line (5, 15), the first dilution-gas supply line (8, 18) being arranged upstream of the means (7, 17) for controlling the temperature of the line, and comprising a gas-inlet member (31), the temperature of which can be controlled to a gas-inlet temperature (T₅) using a means (32) for controlling the temperature of the gas inlet, which gas-inlet member is connected by a line to the first transport line (8, 18), an additional dilution-gas supply line (34) opening into the gas-inlet member (31), upstream of the means (32) for controlling the temperature of the gas-inlet, in order to feed a stream of dilution gas into the gas-inlet member (31), by means of which the gaseous starting material can be fed into a process chamber (30) that has a susceptor (35), which can be temperature controlled to a susceptor temperature (T₆) using a means (27) for controlling the temperature of the susceptor such that a layer grows on the substrate (20) lying on the susceptor (35), by means of the gaseous starting material, and a controller controlling the temperature of the means (2, 12) for controlling the temperature of the source to the source temperature (T₁, T₁'), the means (7, 17) for controlling the temperature of the line to the line temperature (T₂, T₂'), the means (32) for controlling the temperature of the gas-inlet to the gas-inlet temperature (T₅) and the means (27) for controlling the temperature of the susceptor to the susceptor temperature (T₆), **characterised in that** the controller is designed such that, during deposition of the layer, the source temperature (T₁, T₁') is greater than the line temperature (T₂, T₂'), the line temperature (T₂, T₂') is greater than the gas-inlet temperature (T₅) and the gas-inlet temperature (T₅) is greater than the susceptor temperature (T₆).

2. Method for depositing one or more layers on at least one substrate (20), comprising a process-gas source (1, 11) having an evaporator (1', 11'), in which evaporator (1', 11') a solid or liquid starting material is evaporated by supplying heat, generated by a means (2, 12) for controlling the temperature of the source, at a source temperature (T₁, T₁') into a gaseous starting material, a carrier-gas feed line (4, 14) opening into the evaporator (1', 11'), into which carrier-gas feed line a first stream of carrier gas is fed, together with which the gaseous starting material is transported out of the evaporator (1', 11') into a first transport line (5, 15), the temperature of the first transport line (5, 15) being controlled to a line temperature (T₂, T₂') using a means (7, 17) for controlling the temperature of the line, and a first dilution-gas supply line (8, 18) opening into the first transport line (5, 15), by means of which dilution-gas supply line a stream of dilution gas is fed into the first transport line (5, 15), the first dilution-gas supply line (8, 18) being arranged upstream of the means (7, 17) for controlling the temperature of the line, and comprising a gas-inlet member (31), the temperature of which is controlled to a gas-inlet temperature (T₅) using a means (32) for controlling the temperature of the gas inlet, which gas-inlet member is connected by a line to the first transport line (8, 18), an additional dilution-gas supply line (34) opening into the gas-inlet member (31), upstream of the means (32) for controlling the temperature of the gas inlet, in order to feed a stream of dilution gas into the gas-inlet member (31), by means of which the gaseous starting material is fed into a process chamber (30) that has a susceptor (35), which is temperature controlled to a susceptor temperature (T₅) using a means (27) for controlling the temperature of the susceptor, a layer being deposited on the at least one substrate (20) lying on the susceptor (35) by means of the gaseous starting material, **characterised in that**, during deposition of the layer, the source temperature (T₁, T₁') is greater than the line temperature (T₂, T₂'), the line temperature (T₂, T₂') is greater than the gas-inlet temperature (T₅) and the gas-inlet temperature (T₅) is greater than the susceptor temperature (T₆).

3. Device according to claim 1, **characterised by** a process-gas source having a second evaporator (11'), in which second evaporator (11') a solid or liquid second starting material can be evaporated by supplying heat, generated by a second means (12) for controlling the temperature of the source, at a second source temperature (T₁') into a second gaseous starting material, a second carrier-gas supply line (14) opening into the second evaporator (11') in order to feed a second stream of carrier gas in order to transport the second gaseous starting material out of the second evaporator (11') into a second transport line (15), the temperature of the second transport line (15) being controlled to a second line temperature (T₂') using a second means (17) for controlling the temperature of the line, and a second dilution-gas supply line (18) opening into the second transport line (15), through which second dilution-gas supply line a second stream of dilution gas is fed into the second transport line (18), the first transport line (8) and the second transport line (18) opening into a mixer (21) which is controlled to a mixer temperature (T₃) using a means (22) for controlling the temperature of the mixer, a dilution-gas supply line (24) opening into the mixer (21), upstream of the means (22) for controlling the temperature of the mixer, by means of which dilution-gas supply line a dilution-gas stream is fed into the mixer (21).

4. Method according to claim 2, **characterised by** a process-gas source having a second evaporator (11'), in which second evaporator (11') a solid or liquid starting material is evaporated by supplying heat, generated by a means (12) for controlling the temperature of the source, at a second source temperature (T₁') into a second gaseous starting material, a second carrier-gas feed line (14) opening into the second evaporator (11'), into which second carrier-gas feed line a second stream of carrier gas is fed, together with which the second gaseous starting material is transported out of the second evaporator (11') into a second transport line (15), the temperature of the second transport line (15) being controlled to a second line temperature (T₂') using a second means (17) for controlling the temperature of the line, and a second dilution-gas supply line (18) opening into the second transport line (15), through which second dilution-gas supply line a second stream of dilution gas is fed into the second transport line (15), the first transport line (8) and the second transport line (18) opening into a mixer (21), the temperature of which is controlled to a mixer temperature (T₃) using a means (22) for controlling the temperature of the mixer, a dilution-gas supply line (24) opening into the mixer (21), upstream of the means (22) for controlling the temperature of the mixer, by means of which dilution-gas supply line a stream of dilution gas is fed into the mixer (21).

5. Device according to claim 3, **characterised in that** the mixer temperature (T₃) is lower than the first and the second line temperature (T₂, T₂') and is greater than the gas-inlet temperature (T₅).

6. Method according to claim 4, **characterised in that** the mixer temperature (T₃) is lower than the first and the second line temperature (T₂, T₂') and is greater than the gas-inlet temperature (T₅).

7. Device according to claim 3, **characterised by** a transport line (25), arranged downstream of the mixer (21) and upstream of the gas-inlet member (31), for transporting the gaseous starting material from the mixer (21) into the gas-inlet member (31), the temperature of which transport line can be controlled to a line temperature (T₄) using a means (27) for controlling the temperature of the line, a dilution-gas supply line (28) opening into the transport line (25), upstream of the means (27) for controlling the temperature of the line, in order to feed a stream of dilution gas into the transport line (25).

8. Method according to claim 4, **characterised by** a transport line (25), arranged downstream of the mixer (21) and upstream of the gas-inlet member (31), through which transport line the gaseous starting material is transported from the mixer (21) into the gas-inlet member (31), the temperature of which transport line is controlled to a line temperature (T₄) using a means (27) for controlling the temperature of the line, a dilution-gas supply line (28) opening into the transport line (25), upstream of the means (27) for controlling the temperature of the line, by means of which dilution-gas supply line a stream of dilution gas is fed into the transport line (25).

9. Device according to any of claims 3, 5 or 7, **characterised in that** the mixer temperature (T₃) is greater than the line temperature (T₄) and the line temperature (T₄) is greater than the gas-inlet temperature (T₅).

10. Method according to any of claims 4, 6 or 8, **characterised in that** the mixer temperature (T₃) is greater than the line temperature (T₄) and the line temperature (T₄) is greater than the gas-inlet temperature (T₅).

11. Method according to any of claims 2, 4, 6, 8 or 10, **characterised in that**, by feeding a plurality of dilution-gas streams to different locations that are spaced apart from one another in the flow direction, in a heated line connection between the evaporator (1', 11') and the gas-inlet member (31), partial pressure of the gaseous starting material in the carrier-gas stream is reduced, the line connection being heated such that, at each location of the line connection, the temperature in the gas stream is greater than the condensation temperature of the gaseous starting material.

12. Device according to any of claims 1, 3, 5 or 7, **characterised in that** the layers are organic layers.

13. Method according to any of claims 2, 4, 6, 8, 10 or 11, **characterised in that** the layers are organic layers.

## Revendications

1. Dispositif de dépôt d'au moins une couche sur un substrat (20), le dispositif comprenant une source de gaz de traitement (1, 11) comportant un évaporateur (1', 11') dans lequel une matière de départ solide ou liquide peut être vaporisée en une matière de départ gazeuse par apport de chaleur, générée par un dispositif de régulation de température de source (2, 12), à une température de source (T₁, T₁'), un conduit d'alimentation en gaz porteur (4, 14) débouchant dans l'évaporateur (1', 11"), pour introduire un flux de gaz porteur destiné à transporter la matière de départ gazeuse de l'évaporateur (1', 11') dans un premier conduit de transport (5, 15), le premier conduit de transport (5, 15) pouvant être régulé à une température de conduit (T₂, T₂') au moyen d'un dispositif de régulation de température de conduit (7, 17), et un premier conduit de gaz de dilution (8, 18) débouchant dans le premier conduit de transport (5, 15) pour introduire un flux de gaz de dilution dans le premier conduit de transport (5, 15), le premier conduit d'alimentation en gaz de dilution (8, 18) étant disposé en amont du dispositif de régulation de température de conduit (7, 17), et un élément d'entrée de gaz (31) qui peut être régulé à une température d'entrée de gaz (T₅) au moyen d'un dispositif de régulation de température d'entrée de gaz (32) et qui est raccordé au premier conduit de transport (8, 18), un autre conduit d'alimentation en gaz de dilution (34) débouchant dans l'élément d'entrée de gaz (31) en amont du dispositif de régulation de température d'entrée de gaz (32) pour introduire dans l'élément d'entrée de gaz (31) un flux de gaz de dilution avec lequel la matière de départ gazeuse peut être introduit dans une chambre de traitement (30) qui comporte un suscepteur (35) qui peut être régulé à une température de suscepteur (T₆) au moyen d'un dispositif de régulation de température de suscepteur (27) de manière à permettre la croissance d'une couche sur le substrat (20), situé sur le suscepteur (35), au moyen de la matière de départ gazeuse et un dispositif de commande régulant le dispositif de régulation de température de source (2, 12) à la température de source (T₁, T₁'), le dispositif de régulation de température de conduit (7, 17) à la température de conduit (T₂, T₂'), le dispositif de régulation de température d'entrée de gaz (32) à la température d'entrée de gaz (T₅) et le dispositif de régulation de température de suscepteur (27) à la température de suscepteur (T₆), **caractérisé en ce que** le dispositif de commande est adapté de telle sorte que lors du dépôt de la couche, la température de la source (T₁, T₁') est supérieure à la température de conduit (T₂, T₂'), la température de conduit (T₂, T₂') est supérieure à la température d'entrée de gaz (T₅) et la température d'entrée de gaz (T₅) est supérieure à la température de suscepteur (T₆).

2. Procédé de dépôt d'au moins une couche sur au moins un substrat (20), au moyen d'une source de gaz de traitement (1, 11) comportant un évaporateur (1', 11') dans lequel une matière de départ solide ou liquide peut être vaporisée en une matière de départ gazeuse par apport de chaleur, générée par un dispositif de régulation de température de source (2, 12), à une température de source (T₁, T₁'), un conduit d'alimentation en gaz porteur (4, 14) débouchant dans l'évaporateur (1', 11"), conduit d'alimentation en gaz porteur dans lequel un flux de gaz porteur est introduit au moyen duquel la matière de départ gazeuse est transportée de l'évaporateur (1', 11') dans un premier conduit de transport (5, 15), le premier conduit de transport (5, 15) pouvant être régulé à une température de conduit (T₂, T₂') au moyen d'un dispositif de régulation de température de conduit (7, 17), et un premier conduit de gaz de dilution (8, 18) débouchant dans le premier conduit de transport (5, 15), lequel premier conduit de gaz de dilution permet d'introduire un flux de gaz de dilution dans le premier conduit de transport (5, 15), le premier conduit d'alimentation en gaz de dilution (8, 18) étant disposé en amont du dispositif de régulation de température de conduit (7, 17), et au moyen d'un élément d'entrée de gaz (31) qui peut être régulé à une température d'entrée de gaz (T₅) au moyen d'un dispositif de régulation de température d'entrée de gaz (32) et qui est raccordé au premier conduit de transport (8, 18), un autre conduit d'alimentation en gaz de dilution (34) débouchant dans l'élément d'entrée de gaz (31) en amont du dispositif de régulation de température d'entrée de gaz (32) pour introduire dans l'élément d'entrée de gaz (31) un flux de gaz de dilution avec lequel la matière de départ gazeuse est introduite dans une chambre de traitement (30) qui comporte un suscepteur (35) qui peut être régulé à une température de suscepteur (T₆) au moyen d'un dispositif de régulation de température de suscepteur (27), une couche étant déposée sur l'au moins un substrat (20), situé sur le suscepteur (35), au moyen de la matière de départ gazeuse, **caractérisé en ce que**, lors du dépôt de la couche, la température de la source (T₁, T₁') est supérieure à la température de conduit (T₂, T₂'), la température de conduit (T₂, T₂') est supérieure à la température d'entrée de gaz (T₅) et la température d'entrée de gaz (T₅) est supérieure à la température de suscepteur (T₆) .

3. Dispositif selon la revendication 1, **caractérisé par** une source de gaz de traitement comportant un deuxième évaporateur (11') dans lequel une deuxième matière de départ solide ou liquide peut être vaporisée en une deuxième matière de départ gazeuse par apport de chaleur, générée par un deuxième dispositif de régulation de température de source (12), à une deuxième température de source (T₁'), un deuxième conduit d'alimentation en gaz porteur (14) débouchant dans le deuxième évaporateur (11') pour introduire un flux de gaz porteur destiné à transporter la deuxième matière de départ gazeuse du deuxième évaporateur (11') dans un deuxième conduit de transport (15), le deuxième conduit de transport (15) pouvant être régulé à une deuxième température de conduit (T₂') au moyen d'un deuxième dispositif de régulation de température de conduit (17), et un deuxième conduit de gaz de dilution (18) débouchant dans le deuxième conduit de transport (15) pour introduire un flux de gaz de dilution dans le deuxième conduit de transport (15), le premier conduit de transport (8) et le deuxième conduit de transport (18) débouchant dans un mélangeur (21) qui est régulé à une température de mélangeur (T₃) au moyen d'un dispositif de régulation de température de mélangeur (22), un conduit d'alimentation en gaz de dilution (24), permettant d'introduire un flux de gaz de dilution dans le dispositif de mélange (21), débouchant dans le dispositif de mélange (21) en amont du dispositif de régulation de température de mélangeur (22).

4. Procédé selon la revendication 2, **caractérisé par** une source de gaz de traitement comportant un deuxième évaporateur (11') dans lequel une deuxième matière de départ solide ou liquide peut être vaporisée en une deuxième matière de départ gazeuse par apport de chaleur, générée par un deuxième dispositif de régulation de température de source (12), à une deuxième température de source (T₁'), un deuxième conduit d'alimentation en gaz porteur (14) débouchant dans le deuxième évaporateur (11') pour introduire un flux de gaz porteur au moyen duquel la deuxième matière de départ gazeuse est transportée du deuxième évaporateur (11') dans un deuxième conduit de transport (15), le deuxième conduit de transport (15) pouvant être régulé à une deuxième température de conduit (T₂') au moyen d'un deuxième dispositif de régulation de température de conduit (17), et un deuxième conduit de gaz de dilution (18) débouchant dans le deuxième conduit de transport (15) et permettant d'introduire un flux de gaz de dilution dans le deuxième conduit de transport (15), le premier conduit de transport (8) et le deuxième conduit de transport (18) débouchant dans un mélangeur (21) qui est régulé à une température de mélangeur (T₃) au moyen d'un dispositif de régulation de température de mélangeur (22), un conduit d'alimentation en gaz de dilution (24), permettant d'introduire un flux de gaz de dilution dans le dispositif de mélange (21), débouchant dans le dispositif de mélange (21) en amont du dispositif de régulation de température de mélangeur (22).

5. Dispositif selon la revendication 3, **caractérisé en ce que** la température de mélangeur (T₃) est inférieure à la première et à la deuxième température de conduit (T₂, T₂') et est supérieure à la température d'entrée de gaz (T₅).

6. Procédé selon la revendication 4, **caractérisé en ce que** la température de mélangeur (T₃) est inférieure à la première température et à la deuxième température de conduit (T₂, T₂') et est supérieure à la température d'entrée de gaz (T₅).

7. Dispositif selon la revendication 3, **caractérisé par** un conduit de transport (25) situé en aval du dispositif de mélange (21) et en amont de l'élément d'entrée de gaz (31) et destiné à transporter la matière de départ gazeuse du dispositif de mélange (21) dans l'élément d'entrée de gaz (31), lequel conduit de transport peut être régulé à une température de conduit (T₄) au moyen d'un dispositif de régulation de température de conduit (27), un conduit d'alimentation en gaz de dilution (28) débouchant dans le conduit de transport (25) en amont du dispositif de régulation de température de conduit (27) pour introduire un flux de gaz de dilution dans le conduit de transport (25).

8. Procédé selon la revendication 4, **caractérisé par** un conduit de transport (25) situé en aval du dispositif de mélange (21) et en amont de l'élément d'entrée de gaz (31) et destiné à transporter la matière de départ gazeuse du dispositif de mélange (21) dans l'élément d'entrée de gaz (31), lequel conduit de transport peut être régulé à une température de conduit (T₄) au moyen d'un dispositif de régulation de température de conduit (27), un conduit d'alimentation en gaz de dilution (28) débouchant dans le conduit de transport (25) en amont du dispositif de régulation de température de conduit (27) et permettant d'introduire un flux de gaz de dilution dans le conduit de transport (25).

9. Dispositif selon l'une des revendications 3, 5 ou 7, **caractérisé en ce que** la température de mélangeur (T₃) est supérieure à la température de conduite (T₄) et la température de conduit (T₄) est supérieure à la température d'entrée de gaz (T₅) .

10. Procédé selon l'une des revendications 4, 6 ou 8, **caractérisé en ce que** la température de mélangeur (T₃) est supérieure à la température de conduit (T₄) et la température de conduit (T₄) est supérieure à la température d'entrée de gaz (T₅) .

11. Procédé selon l'une des revendications 2, 4, 6, 8 ou 10, **caractérisé en ce que** l'alimentation d'une pluralité de flux de gaz de dilution, en différents emplacements espacés les unes des autres dans le sens d'écoulement, dans un raccordement de conduites chauffé situé entre l'évaporateur (1', 11') et l'élément d'entrée de gaz (31) permet de réduire par étapes la pression partielle de la matière de départ gazeuse dans le flux de gaz porteur, le raccordement étant chauffé de telle sorte que, chaque emplacement du raccordement de conduites, la température dans le flux de gaz est supérieure à la température de condensation de la matière de départ gazeuse.

12. Dispositif selon l'une des revendications 1, 3, 5 ou 7, **caractérisé en ce que** les couches sont des couches organiques.

13. Procédé selon l'une des revendications 2, 4, 6, 8, 10 ou 11, **caractérisé en ce que** les couches sont des couches organiques.
